# EUROPÄISCHE PATENTSCHRIFT

(11) **EP 1 171 912 B1**
(45) Veröffentlichungstag und Bekanntmachung des Hinweises auf die Patenterteilung: **24.09.2003**
(21) Anmeldenummer: 00945532.0
(22) Anmeldetag: 16.05.2000
(51) Int. Cl.: H01L 21/768, H01L 23/48, H01L 25/065

(54) **VERFAHREN ZUR VERTIKALEN INTEGRATION VON ELEKTRISCHEN BAUELEMENTEN MITTELS RÜCKSEITENKONTAKTIERUNG**
METHOD FOR THE VERTICAL INTEGRATION OF ELECTRIC COMPONENTS BY REVERSE SIDE CONTACTING
PROCEDE D'INTEGRATION VERTICALE DE COMPOSANTS ELECTRIQUES A L'AIDE D'UN CONTACT ARRIERE

(30) Priorität: 27.05.1999 DE 19924287; 04.12.1999 DE 19958486
(43) Veröffentlichungstag der Anmeldung: 16.01.2002
(73) Patentinhaber: Fraunhofer-Gesellschaft zur Förderung der angewandten Forschung e.V., 80636 München (DE)
(72) Erfinder: RAMM, Peter, D-85276 Pfaffenhofen (DE); KLUMPP, Armin, D-80337 München (DE)
(74) Vertreter: Schoppe, Fritz, Dipl.-Ing.
(86) Internationale Anmeldenummer: DE0001605
(87) Internationale Veröffentlichungsnummer: WO00074134

(56) Entgegenhaltungen:
- JP-A- 63 156 348
- US-A- 5 426 072
- US-A- 5 767 001
- US-A- 5 846 879

## Beschreibung

Die vorliegende Erfindung betrifft ein Verfahren zur Herstellung einer dreidimensionalen integrierten Schaltung. Unter dreidimensionaler Integration versteht man die vertikale Verbindung von Bauelementen, die mittels Planartechnik hergestellt wurden. Die Vorteile eines dreidimensional integrierten mikroelektronischen Systems sind u.a. die bei gleichen Designregeln erreichbaren höheren Packungsdichten und Schaltgeschwindigkeiten gegenüber zweidimensionalen Systemen. Letzteres ist zum einen bedingt durch kürzere Leitungswege zwischen den einzelnen Bauelementen oder Schaltungen, zum anderen durch die Möglichkeit der parallelen Informationsverarbeitung. Die Steigerung der Leistungsfähigkeit des Systems ist bei Realisierung einer Verbindungstechnik mit örtlich frei wählbaren höchstintegrierbaren vertikalen Kontakten optimal.

Zur Herstellung dreidimensionaler Schaltungsanordnungen mit frei wählbaren vertikalen Kontakten sind u.a. die folgenden Verfahren bekannt.

In Y. Akasaka, Proc. IEEE 74 (1986) 1703, wird beispielsweise vorgeschlagen, auf eine fertig prozessierte Bauelementeschicht polykristallines Silizium abzuscheiden und zu rekristallisieren, so daß in der rekristallisierten Schicht weitere Bauelemente gefertigt werden können. Nachteile dieses Verfahrens sind die ausbeutereduzierende Degradation der Bauelemente in der unteren Ebene durch die hohe thermische Belastung beim Rekristallisierungsprozeß sowie die notwendigerweise serielle Prozessierung des Gesamtsystems. Letzteres bedingt zum einen entsprechend lange Durchlaufzeiten bei der Fertigung und hat zum anderen eine Ausbeuteminderung durch Aufsummierung der prozeßbedingten Ausfälle zur Folge. Beides erhöht die Fertigungskosten beträchtlich gegenüber einer Prozessierung der einzelnen Ebenen getrennt voneinander in verschiedenen Substraten.

Aus Y. Hayashi et al., Proc. 8^{th} Int. Workshop on Future Electron Devices, 1990, p. 85, ist es darüber hinaus bekannt, zunächst die einzelnen Bauelementeebenen getrennt voneinander in verschiedenen Substraten herzustellen. Anschließend werden die Substrate gedünnt, mit Vorder- und Rückseitenkontakten versehen und mittels eines Bondverfahrens vertikal verbunden. Vorteil dieses Verfahrens ist, daß die vertikale Integration mit dem Bondverfahren abgeschlossen ist und somit keine Prozeßschritte an den gestapelten Substraten mehr notwendig sind. Erheblich einschränkend für die Anwendbarkeit ist jedoch, daß hier die Substrate bis auf wenige 0,1 µm gedünnt werden müssen (vollständiges Entfernen des Substratmaterials im Bereich der lateralen Isolationsstrukturen), so daß dieses Verfahren nicht für die vertikale Integration gemäß Standard-Halbleitertechnologien gefertigter Bauelemente in Frage kommt.

In der US 4,939,568 wird ein Verfahren zur Herstellung einer dreidimensionalen integrierten Schaltungsstruktur durch Stapelung einzelner ICs zu einem Einzelchipstapel auf einem Trägersubstrat beschrieben. Hierzu wird zunächst ein Substrat mit fertigprozessierten ICs in einzelne Chips unterteilt, womit die Prozessierung auf Waferebene beendet ist. Die Chips werden getestet, und ein erster einzelner Chip wird mittels Thermokompression auf ein Trägersubstrat aufgebracht. Nach diesem Schritt wird ein weiterer Chip in der gleichen Weise auf den ersten Chip aufgebracht. Es wird somit zunächst ein erster Chipstapel fertiggestellt, bevor mit der Herstellung eines weiteren Chipstapel auf einem anderen Trägersubstrat begonnen wird. Eine Weiterprozessierung der Chipstapel auf Waferebene ist mit diesem Verfahren daher nicht möglich.

Ein bedeutender Nachteil der bisher genannten Verfahren ist dadurch bedingt, daß die in der Siliziumtechnologie zur Verfügung stehenden Geräte nur eine Bearbeitung (Prozessierung) von scheibenförmigen Substraten, den sog. Wafern, zulassen. Eine Prozessierung davon verschiedener Substrate, insbesondere von einzelnen Chips, ist nur in experimentellen Versuchsanlagen möglich, jedoch nicht im Rahmen einer industriellen Fertigung mit den geforderten hohen Ausbeuten.

In der US 5,563,084 wird ein Verfahren zur Herstellung einer dreidimensionalen integrierten Schaltung beschrieben, bei dem die Verbindung der einzelnen Bauelementeebenen über besonders geformte Vialöcher hergestellt wird. Bei diesem Verfahren werden zwei fertig prozessierte Substrate verbunden. Vorher wird jedoch das obere Substrat einem Funktionstest unterzogen, mit dem die intakten Chips des Substrates selektiert werden. Anschließend wird dieses Substrat von der Rückseite her gedünnt, in einzelne Chips zerlegt und nur selektierte, intakte Chips nebeneinander auf das mit einer Haftschicht versehene untere Substrat justiert aufgebracht. Nachteilig an diesem Verfahren ist jedoch, daß die vertikalen elektrischen Verbindungen zwischen den gestapelten Bauelementeebenen erst nachfolgend durch Weiterprozessierung auf Waferebene realisiert werden (Verdrahtung). Hierzu ist zum einen ein geeignetes Planarisierungsverfahren einzusetzen, welches die ausgeprägte Topographie der Chip-Stapel einebnet, so daß diese gemäß Standard-Scheibenfertigungsprozessen bearbeitet werden können. Zum anderen ist aufgrund der endlichen Platziergenauigkeit beim Aufbringen der Chips die Integrationsdichte der abschließenden Verdrahtung zusätzlich eingeschränkt. Die für das Öffnen von Vialöchern auf die Metallisierungsebene des aufgebrachten Chips und die nachfolgende Strukturierung der abschließenden Verdrahtungsebene notwendigen Lithographieschritte auf Scheibenebene müssen entsprechend große Justiervorhalte berücksichtigen, um jeweils über der gesamten Fläche des Wafers im "Fangbereich" zu liegen.

Aus der US 5,627,106 ist darüber hinaus ein Verfahren zum dreidimensionalen Verbinden von Halbleiterbauelementen bekannt, bei dem Halbleiterbauelementstrukturen in und auf der Oberseite eines ersten Halbleitersubstrats erzeugt werden. Anschließend werden tiefe Gräben in das erste Halbleitersubstrat geätzt und mit einem leitenden Material gefüllt. Darauf folgend wird die Rückseite des ersten Halbleitersubstrats abgeschliffen und poliert, so daß die mit leitendem Material gefüllten Gräben hervorstehen. Das zweite Halbleitersubstrat weist ebenfalls Halbleiterbauelementstrukturen auf. Zusätzlich werden Verbindungsfenster in das zweite Halbleitersubstrat geätzt, in die in einem folgenden Schritt die hervorstehenden Gräben des ersten Halbleiterbauelements eingepaßt werden. Erst nach dem mechanischen Verbinden der beiden Substrate werden die Halbleiterbauelementstrukturen des ersten Halbleitersubstrats mit dem leitenden Material in den Gräben elektrisch leitend verbunden. Nachteilig bei diesem Verfahren ist insbesondere, daß die mit leitendem Material gefüllten hervorstehenden Gräben leicht abbrechen, was die praktische Handhabung des Verfahrens erschwert.

In der deutschen Patentschrift DE 44 33 846 wird überdies ein Verfahren zur Herstellung einer vertikalen integrierten Schaltungsstruktur beschrieben, bei dem die einzelnen Bauelementelagen in unterschiedlichen Substraten unabhängig voneinander prozessiert und nachfolgend zusammengefügt werden. Dazu werden zunächst auf der Vorderseite eines fertigprozessierten Topsubstrates Vialöcher geöffnet, die alle vorhandenen Bauelementelagen durchdringen. Danach wird ein Handlingsubstrat aufgebracht und das Topsubstrat von der Rückseite her bis an die Vialöcher gedünnt, Anschließend wird ein fertigprozessiertes Bottomsubstrat mit dem Topsubstrat verbunden. Nach dem Entfernen des Handlingsubstrats werden die Vialöcher durch die verbleibenden Schichten bis auf eine Metallsierungsebene des Bottomsubstrats verlängert und der elektrische Kontakt zwischen Top- und Bottomsubstrat hergestellt.

Aus der nachveröffentlichten Europäischen Patentoffenlegungsschrift EP-A-0 926 726 ist überdies ein Verfahren zum Aufbringen von vereinzelten Chips auf Leiterplatten bekannt. Bei diesem Verfahren werden die auf der Vorderseite der Chips befindlichen Bauelementstrukturen durch Durchgangslöcher durcn die Chips hindurch mit elektrischen Kontakten auf der Leiterplatte elektrisch und mechanisch verbunden.

Aus der Europäischen Patentoffenlegungsschrift EP-A-0 531 723 ist darüber hinaus ein Verfahren zum dreidimensionalen Stapeln von Halbleiter-Chips bekannt. Bei diesem Verfahren wird die elektrische Verbindung durch eine nicht hochschmelzende Lötverbindung realisiert, und die mechanische Verbindung der Chips mit dem Substrat erfolgt über Polyimid oder eine andere Verbindungsschicht. Entsprechend wird der bereits aufgebaute Chipstapel mechanisch nicht instabil, wenn er erneut erwärmt wird, um einen weiteren Chip aufzubringen.

Dieses bekannte Verfahren ist daher dahingehend problematisch, daß es zum einen schwierig ist, eine Chipoberfläche aus einerseits Polyimid und andererseits dem in die Gräben gefüllten Lotmaterial einzuebnen. Zum anderen weist eine aus mehreren nebeneinander angeordneten verschiedenen Materialien bestehende Chipoberfläche jeweils verschiedene thermische Eigenschaften auf, die sich negativ auswirken, wenn der Chipstapel mehrfach erwärmt wird, um immer wieder neue Chips aufzubringen.

Das U.S.-Patent Nr. 5,426,072 offenbart ein Verfahren zum Herstellen einer dreidimensional integrierten Schaltung aus gestapelten SOI-Wafern unter Verwendung eines temporären Siliziumsubstrats. Hierzu wird ein SOI-Substrat derart bearbeitet, daß es Durchgangslöcher durch die Silizium-Schicht des SOI-Substrats aufweist, die später durch den Isolator fortgesetzt werden. Das Substrat des SOI-Wafers wird entfernt, woraufhin beide Seiten der Durchgangslöcher mit Indium-Höckern (Bumps) versehen werden. Ein weiteres Substrat wird hergestellt, das ebenfalls Indium-Höcker auf weist. Die beiden Substrate werden aufeinander plaziert, so daß sich die Indium-Höcker berühren, woraufhin ein Kaltschweißverfahren angewendet wird, um die Indium-Höcker miteinander zu fusionieren. Der zwischen den Höckern bestehende Zwischenraum wird mit einem Epoxidharzklebstoff gefüllt, um eine mechanische Unterstützung der Verbindung zwischen dem oberen und dem unteren Substrat zu schaffen.

Die JP 63-156348 A offenbart ein Halbleiter-Bauelement mit aufeinander gestapelten Halbleiterchips. Auf einem Halbleiterchip des Stapels sind auf einer Vorderseite und auf einer Rückseite Verbindungselektroden angebracht. In den Halbleiterchips befinden sich ferner interne Leiter, um die verbindungselektroden auf der Vorderseite und der Rückseite miteinander zu verbinden. Die Verbindungselektroden eines Halbleiter-Bauelements liegen in dem Stapel den gegenüberliegenden Verbindungselektroden des nächsten Halbleiter-Bauelements gegenüber. Die Verbindungselektroden der gegenüberliegenden Halbleiterchips umfassen Gold-Höcker. Die Höcker aus Gold sind dort angeordnet, wo elektrische Verbindungen benötigt werden. Die inneren Leiter sind durch isolationsschichten von dem Halbleiterchip isoliert, in dem sie sich erstrecken. Die Gold-Höcker zweier gegenüberliegender Halbleiterchips werden mittels eines Thermokompressions-Bondverfahrens miteinander verbunden, damit sie elektrisch verbunden und mechanisch gekoppelt sind. Statt Gold kann auch Lötmittel verwendet werden.

Der vorliegenden Erfindung liegt die Aufgabe zugrunde, ein verbessertes Verfahren zum Verbinden zweier Halbleiter-Bauelemente oder auch einer Vielzahl von Halbleiter-Bauelementen zu schaffen.

Gemäß der vorliegenden Erfindung wird die Aufgabe durch das Verfahren nach Anspruch 1 und 12 gelöst.

Die vorliegende Erfindung schafft somit ein Verfahren zum Verbinden zweier Halbleiter-Bauelemente mit den Schritten: Bereitstellen von ersten Bauelementstrukturen in einer ersten Hauptoberfläche eines ersten Halbleiter-Substrats, mit ersten Kontaktbereichen; Ausbilden von mit elektrisch leitendem Material gefüllten Kontaktlöchern in dem ersten Halbleiter-Substrat, welche gegenüber dem ersten Halbleiter-Substrat elektrisch isoliert sind, sich bis zur zweiten Hauptoberfläche des ersten Halbleiter-Substrats erstrecken und über ein elektrisch leitendes Verbindungsmaterial mit den ersten Kontaktbereichen elektrisch leitend verbunden sind, Ausbilden von ersten Kontaktflecken auf der zweiten Hauptoberfläche des ersten Halbleiter-Substrats, die über das elektrisch leitende Material in den Kontaktlöchern mit den ersten Kontaktbereichen elektrisch leitend verbunden sind; Bereitstellen eines zweiten Halbleiter-Substrats mit zweiten Baulementstrukturen, die zweite Kontaktbereiche auf weisen Ausbilden von zweiten Kontaktflecken, die mit den zweiten Kontaktbereichen elektrisch leitend verbunden sind; Verbinden von erstem und zweiten Halbleiter-Substrat, so daß sowohl eine elektrisch leitfähige als auch eine mechanische Verbindung der beiden Substrate über die ersten und zweiten Kontaktflecken erfolgt, wobei Materialien für die ersten und zweiten Kontaktflecken derart ausgewählt sind, wie im letzten Absatz von Anspruch 1 definiert.

Bei dem erfindungsgemäßen Verfahren werden zwei fertig prozessierte Substrate, die jeweils Schaltungsstrukturen und hochdotierte Anschlußbereiche und/oder Metallisierungsebenen enthalten, über metallische Schichten miteinander verbunden. Beim oberen Substrat wird hierzu zunächst eine Rückseitenverdrahtung bereitgestellt, wodurch elektrische Verbindungen zwischen ersten Kontaktbereichen, beispielsweise hochdotierten Anschlußbereichen oder Metallisierungsebenen der Bauelementelage, zur Rückseite des Bauelementesubstrats hergestellt werden (Rückseitenkontakte). Das untere Substrat wird mit entsprechend platzierten metallischen Vorderseitenkontakten versehen, so daß durch ein geeignetes Bondverfahren vertikale mechanische und elektrische Verbindungen zwischen den Rückseitenkontakten des oberen Substrats und den Vorderseitenkontakten des unteren Substrats realisiert werden können.

Vorteilhaft bei dem erfindungsgemäßen Verfahren ist, daß dadurch, daß durch ein geeignetes Bondverfahren vertikale mechanische und elektrische Verbindungen zwischen oberem und unterem Substrat realisiert werden, keine gesonderte Schicht wie beispielsweise eine Polyimidschicht zur mechanischen Verbindung von oberem und unterem Substrat aufgebracht werden muß. Entsprechend ist es im Gegensatz zum Stand der Technik bei dem erfindungsgemäßen Verfahren auch nicht notwendig, diese Verbindungsschicht mit dem Lotsystem einzuebnen, was sich in der Praxis als schwierig durchführbar erwiesen hat. Sind mechanische Verbindungsschicht und Lotsystem nicht korrekt eingeebnet, kann es passieren, daß die Lotsysteme von oberem und unterem Substrat nicht in ausreichendem Kontakt miteinander stehen, so daß keine zuverlässige elektrische Verbindung zwischen oberem und unterem Substrat entsteht. Ein weiterer Nachteil bei der Verwendung einer mechanischen Verbindungsschicht besteht darin, daß das mechanische und das elektrische Verbindungsmaterial verschiedene thermische Eigenschaften aufweisen. Werden zwei Substrate unter Erhöhung der Temperatur aufeinandergefügt, so ist das eine Material bereits erweicht, während das andere Material noch fest ist. Dies macht den Prozeß des Aneinanderfügens zusätzlich kompliziert.

Das bei der vorliegenden Erfindung eingesetzte Bondverfahren kann beispielsweise gemäß einem Niedertemperaturlötverfahren durchgeführt werden, das auf der "Solid-Liquid-Interdiffusion" zweier Metalle beruht und stabile Verbindungen bis weit oberhalb der Bond-Temperatur ermöglicht. Erfindungsgemäß ist die Verbindung eine eutektische Legierung, deren Schmelzpunkt nach dem Zusammenfügen höher als die Schmelzpunkte der einzelnen Komponenten vor dem Zusammenfügen ist. Es bildet sich daher eine insofern irreversible Verbindung, als daß sie stabil ist gegenüber denjenigen Bedingungen, unter denen sie entstanden ist. Beispiele für Metallkombinationen, die gemäß der vorliegenden Erfindung für die elektrische und mechanische Verbindung verwendet werden können, sind Kupfer und Zinn oder Gold und Titan jeweils für Vorder- und Rückseitenkontakte.

Gemäß der vorliegenden Erfindung kann in gleicher Weise nun auch eine weitere Bauelementelage chipweise aufgebracht werden, ohne daß die zuvor aufgebrachten Bauelementelagen wieder instabil werden. Dabei dient der bisher hergestellte Bauelementestapel mit zugehörigem Substrat als neues unteres Substrat. Entsprechend ist bei diesem Verfahren die Anzahl der Ebenen nicht beschränkt. Außerdem kann nicht nur eine Einzelebene sondern auch ein bereits aus mehrereren Ebenen bestehender Teilstapel wie ein einzelner Chip aufgebracht werden.

Gemäß der vorliegenden Erfindung ist es natürlich auch möglich, daß das vorstehende Lotsystem stellenweise lediglich als Kleber verwendet wird, d.h. mechanische nicht aber elektrische Kontakte bewirkt.

Als Substrate sind monokristalline Siliziumsubstrate, SOI-Substrate oder Substrate verschiedener Technologiefamilien, wie beispielsweise III-V-Halbleiter geeignet. Bevorzugte Ausführungsformen der vorliegenden Erfindung werden nachfolgend unter Bezugnahme auf die beiliegenden Zeichnungen detailliert erläutert.
Die Fig. 1a bis 1d zeigen beispielhaft eine Prozessierungssequenz für das obere Substrat.
Die Fig. 2a und 2b veranschaulichen beispielhaft das Zusammenfügen von oberem und unteren Substrat;
Fig. 3 zeigt den zusammengefügten Stapel aus oberem und unteren Substrat; und Fig. 4 zeigt den zusammengefügten Stapel aus oberem und unteren Substrat nach Entfernen des Hilfssubstrats.

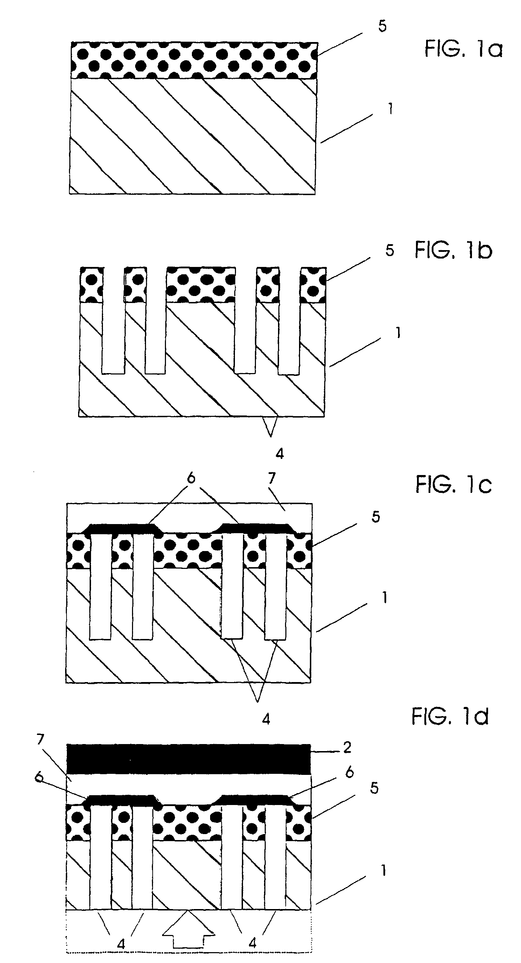

In den Fig. 1a bis 1d bezeichnet Bezugszeichen 1 das obere Substrat. Nach einer vorbereitenden Prozessierung des oberen Substrats werden die Kontaktlöcher 4, sogenannte Deep-Vias, d.h. vertikal integrierte Anschlüsse, mit einem Aspektverhältnis von Tiefe zu Durchmesser von bis zu 50:1 in dem oberen Substrat ausgebildet. Die Ausbildung der Kontaktlöcher 4 erfolgt im allgemeinen durch die Oxidschichten 5 auf der Substratoberfläche hindurch. Die Oberfläche der Kontaktlöcher wird mit einer Isolationsschicht, beispielsweise Siliziumdioxid, und einer Haftschicht und Diffusionssperre, beispielsweise Titannitrid, ausgekleidet. Danach erfolgt ein lunkerfreies Füllen der Kontaktlöcher mit einem elektrisch leitfähigen Material wie beispielsweise Kupfer oder Wolfram. Nach einer flächigen Rückätzung verbleiben isolierte, elektrisch leitfähige und gefüllte Kontaktlöcher 4, die mit nachfolgenden Metallisierungsschritten nach den Erfordernissen der elektronischen Schaltung untereinander und mit den elektrisch aktiven Gebieten, beispielsweise hochdotierten Bereichen oder Metallisierungsebenen, der Schaltung verbunden werden. Nach Bereitstellen der Metallisierung 6 wird eine Passivierungs- und Schutzschicht 7 abgeschieden.

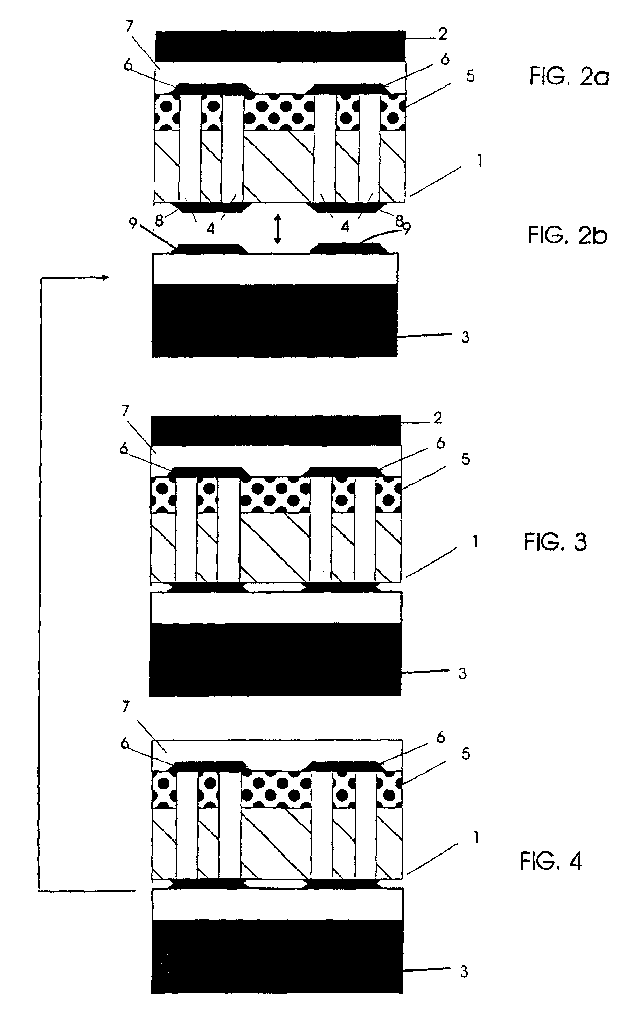

Nachfolgend wird, wie in Fig. 1d gezeigt, das obere Substrat zur mechanischen Unterstützung auf ein Hilfssubstrat 2 geklebt und von der Rückseite gedünnt, bis die gefüllten Kontaktlöcher von der Rückseite her freigelegt sind. Typische Dicken des gedünnten oberen Substrats betragen ungefähr 10 µm. Die Rückseite wird danach durch die Bearbeitungsfolge Abscheidung eines Isolatormaterials , Abscheidung einer Haftschicht, Öffnung dieser Schichtkombination im Bereich der Kontaktlöcher, Aufbringen einer Metallisierung und Strukturierung mit ersten Kontaktflecken 8 versehen, wie in Fig. 2a gezeigt ist. Diese Kontaktflecken 8 sind damit über die Kontaktlöcher 4 mit den elektrisch aktiven Bereichen auf der Vorderseite verbunden. Parallel zur Bearbeitung des oberen Substrats 1 wird, wie in Fig.2b gezeigt ist, das untere Substrat 3 mit zweiten Kontaktflecken 9 versehen, die spiegelbildlich zu den ersten Kontaktflecken 8 auf der Rückseite des gedünnten oberen Substrats angeordnet sind, so daß sich beim justierten Aufeinandersetzen von oberem auf das untere Substrat die Kontaktflecken 8, 9 paarweise berühren, wie in Fig. 3 gezeigt ist. Typische Durchmesser der sich berührenden Kontaktflecken betragen dabei 5 µm. Diese kleinen Durchmesser sind durch das hohe Aspektverhältnis der Kontaktlöcher 4 bedingt.

Die Justage kann dabei anhand von Justiermarken aus geeignet angeordneten Kontaktlochreihen erfolgen. Sowohl die ersten als auch die zweiten Kontaktflecken sind vorzugsweise in einer Materialkombination ausgeführt, die es ermöglicht, durch eine Temperaturerhöhung während des Kontaktes, der im allgemeinen unter gleichzeitiger Anwendung einer mechanischen Kraft stattfindet, elektrisch leitfähige und mechanisch stabile Verbindungen zu erzeugen. Dabei handelt es sich bevorzugt um Materialkombinationen bei denen eine Verbindung durch Interdiffusion hergestellt wird. Insbesondere kann dies durch eine Kombination aus Kupfer auf dem unteren Substrat und Zinn auf der Rückseite des oberen Substrats realisiert werden. Nach erfolgter Verbindung von oberem und unteren Substrat 1, 3 kann das Hilfssubstrat 2 entfernt werden und der nun vorliegende Substratstapel gereinigt werden.

Gemäß einer bevorzugten Ausführungsform ist es nun möglich, den somit erhaltenen Substratstapel mit weiteren Bauelementesubstraten zu verbinden. Dabei dient der erhaltene Substratstapel als das untere Substrat und wird, wie in den Fig. 4 und 2b gezeigt, weiterverarbeitet, wobei zunächst die Schutzschicht 7 freigelegt werden muß, um die obere Metallisierung 6 freizulegen.

## Patentansprüche

1. Verfahren zum Verbinden zweier Halbleiter-Bauelemente mit den Schritten
- Bereitstellen von ersten Bauelementstrukturen in einer ersten Hauptoberfläche eines ersten Halbleiter-Substrats (1), mit ersten Kontaktbereichen;
- Ausbilden von mit elektrisch leitendem Material gefüllten Kontaktlöchern (4) in dem ersten Halbleiter-Substrat (1), welche gegenüber dem ersten Halbleiter-Substrat (1) elektrisch isoliert sind, sich bis zu einer zweiten Hauptoberfläche des ersten Halbleiter-Substrats (1) erstrecken und über ein elektrisch leitendes Verbindungsmaterial (6) mit den ersten Kontaktbereichen elektrisch leitend verbunden sind;
- Ausbilden von ersten Kontaktflecken (8) auf der zweiten Hauptoberfläche des ersten Halbleiter-Substrats (1), die über das elektrisch leitende Material in den Kontaktlöchern (4) mit den ersten Kontaktbereichen elektrisch leitend verbunden sind;
- Bereitstellen eines zweiten Halbleiter-Substrats (3) mit zweiten Bauelementstrukturen, die zweite Kontaktbereiche aufweisen;
- Ausbilden von zweiten Kontaktflecken (9), die mit den zweiten Kontaktbereichen elektrisch leitend verbunden sind;
- Verbinden von erstem (1) und zweiten (3) Halbleiter-Substrat, so daß sowohl eine elektrisch leitfähige als auch eine mechanische Verbindung der beiden Substrate über die ersten (8) und zweiten (9) Kontaktflecken erfolgt,
wobei Materialien für die ersten und die zweiten Kontaktflecken (8, 9) derart ausgewählt sind, daß eine durch den Schritt des Verbindens erhaltene Verbindung der ersten und der zweiten Kontaktflecken eine eutektische Legierung ist und einen höheren Schmelzpunkt hat als die Schmelzpunkte der Materialien für die ersten und die zweiten Kontaktflecken vor dem Schritt des Verbindens.

2. Verfahren nach Anspruch 1, bei dem die Kontaktbereiche hochdotierte Anschlußbereiche sind.

3. Verfahren nach Anspruch 1, bei dem die Kontaktbereiche Metallisierungsebenen sind.

4. Verfahren nach Anspruch 3, bei dem die ersten Kontaktbereiche auf der ersten Hauptoberfläche angeordnete Metallisierungsebenen sind.

5. Verfahren nach Anspruch 3, bei dem die ersten Kontaktbereiche unterhalb der ersten Hauptoberfläche angeordnete Metallisierungsebenen sind.

6. Verfahren nach einem der vorhergehenden Ansprüche, bei dem das elektrisch leitende Verbindungsmaterial über eine zusätzliche Metallislerungssequenz aufgebracht wird.

7. Vertahren nach einem der vorhergehenden Ansprüche, bei dem die erste Hauptoberfläche des ersten Halbleiter-Substrats (1) nach Ausbilden des Kontaktlöcher mit einem Hilfssubstrat (2) verbunden wird und anschließend von der der ersten Hauptoberfläche gegenüberliegenden Seite des ersten Halbierter-Substrats (1) her gedünnt wird.

8. Verfahren nach einem der vorhergehenden Ansprüche, bei dem das erste (1) und das zweite (3) Halbleitersubsträt zunächst identisch bearbeitet werden und anschließend spiegelbildlich zueinander zusammengefügt werden.

9. Verfahren nach einem der vorhergehenden Ansprüche,
bei dem als Material für die ersten Kontaktflecken (8) Zinn verwendet wird und bei dem als Material für die zweiten Kontaktflecken (9) Kupfer verwendet wird, oder
bei dem als Material für die ersten Kontaktflecken (8) Titan verwendet wird und bei dem als Material für die zweiten Kontaktflecken (9) Gold verwendet wird.

10. Verfahren nach einem der vorhergehenden Ansprüche, bei dem nicht alle ersten (8) und zweiten (9) Kontaktflecken jeweils mit den ersten und zweiten Kontaktbereichen elektrisch leitend verbunden werden.

11. Verfahren nach einem der vorhergehenden Ansprüche, bei dem durch ein justiertes Platzieren der zweiten Hauptoberfläche des ersten Halbleitersubstrats (1) auf der Oberfläche des zweiten Halbleitersubstrats (3) mit gleichzeitiger Temperaturerhöhung und Kraftanwendung eine elektrisch leitfähige Verbindung bereitgestellt wird.

12. Verfahren zum Verbinden einer Vielzahl von Halbleiter-Bauelementen, bei dem das Verfahren nach einem der vorhergehenden Ansprüche iterativ wiederholt wird und das jeweils n-te Halbleiter-Bauelement die Rolle des ersten Halbleiter-Bauelements übernimmt, während der Stapel aus (n-1) zusammengefügten Halbleiter-Bauelementen die Rolle des zweiten Halbleiter-Bauelements übernimmt.

## Claims

1. A method of connecting two semiconductor components comprising the steps of
- providing in a first main surface of a first semiconductor substrate (1) first component structures including first contact areas;
- forming in said first semiconductor substrate (1) via holes (4) filled with electrically conductive material and electrically insulated from said first semiconductor substrate (1), said via holes (4) extending down to the second main surface of the first semiconductor substrate (1) and being connected in an electrically conductive manner to said first contact areas via an electrically conductive connection material (6);
- forming on the second main surface of the first semiconductor substrate (1) first lands (8) which are connected in an electrically conductive manner to the first contact areas via the electrically conductive material in the via holes (4);
- providing a second semiconductor substrate (3) having second component structures including second contact areas;
- forming second lands (9) which are connected in an electrically conductive manner to the second contact areas;
- connecting the first (1) and the second (3) semiconductor substrate in such a way that an electrically conductive as well as a mechanical connection between the two substrates is established via the first (8) and the second (9) lands,
wherein materials for the first and second lands (8, 9) are selected in such a way that a connection, obtained by the step of connecting, of the first and second lands is an eutectic alloy and has a melting point higher than the melting points of the materials for the first and second lands prior to the joining process.

2. A method according to claim 1, wherein the contact areas are heavily doped connecting areas.

3. A method according to claim 1, wherein the contact areas are metallization planes.

4. A method according to claim 3, wherein the first contact areas are metallization planes arranged on the first main surface.

5. A method according to claim 3, wherein the first contact areas are metallization planes arranged below the first main surface.

6. A method according to one of the preceding claims, wherein the electrically conductive connection material is applied via an additional metallization sequence.

7. A method according to one of the preceding claims, wherein, after the formation of the via holes, the first main surface of the first semiconductor substrate (1) is connected to an auxiliary substrate (2) and is then thinned from the side of the first semiconductor substrate (1) located opposite said first main surface.

8. A method according to one of the preceding claims, wherein the first (1) and the second (3) semiconductor substrate are first subjected to identical processing steps and are then joined in a mirror-inverted mode of arrangement.

9. A method according to one of the preceding claims,
wherein tin is used as the material for the first lands (8) and copper is uses as the material for the second lands (9), or
wherein titanium is used as the material for the first lands (8) and gold is used as the material for the second lands (9).

10. A method according to one of the preceding claims, wherein not all the first (8) and second (9) lands are connected in an electrically conductive manner to respective ones of the first and second contact areas.

11. A method according to one of the preceding claims, wherein an electrically conductive connection is established by placing the second main surface of the first semiconductor substrate (1) onto the surface of the second semiconductor substrate (3) in an aligned mode of arrangement, with a simultaneous increase in temperature and application of force.

12. A method of connecting a plurality of semiconductor components, wherein the method according to one of the preceding claims is repeated iteratively and wherein the respective nth semiconductor component plays the part of the first semiconductor component, whereas the stack of (n-1) combined semiconductor components plays the part of the second semiconductor component.

## Revendications

1. Procédé pour assembler deux composants à semi-conducteur, aux étapes consistant à
- préparer des premières structures de composants dans une première surface principale d'un substrat à semi-conducteur (1), avec des premières zones de contact ;
- former des trous de contact (4), remplis de matériau électroconducteur, dans le premier substrat à semi-conducteur (1), qui sont isolés électriquement du premier substrat à semi-conducteur (1), qui s'étendent jusqu'à une seconde surface principale du premier substrat à semi-conducteur (1) et qui sont reliés de manière électroconductrice, par l'intermédiaire d'un matériau de connexion électroconducteur (8), avec les premières zones de contact :
- former des premières taches de contact (8) sur la seconde surface principale du premier substrat à semi-conducteur (1) qui sont reliées de manière électroconductrice, par l'intermédiaire du matériau électroconducteur dans les trous de contact (4), aux premières zones de contact :
- préparer un second substrat à semi-conducteur (3) avec deux structures de composants présentant des secondes zones de contact ;
- former des secondes taches de contact (9) qui sont reliées de manière électroconductrice aux secondes zones de contact ;
- assembler le premier (1) et le second substrat à semi-conducteur (3), de sorte qu'il se produise tant un assemblage électroconducteur qu'un assemblage mécanique des deux substrats, par l'intermédiaire des premières (8) et secondes (9) taches de contact,
les matériaux pour les premières et les secondes taches de contact (8, 9) étant choisis de telle sorte qu'un assemblage des premières et des secondes taches de contact obtenus par l'étape d'assemblage soit un alliage eutectique et possède un point de fusion supérieur aux points de fusion des matériaux pour les premières et les secondes taches de contact avant l'étape d'assemblage.

2. Procédé selon la revendication 1, dans lequel les zones de contact sont des zones de raccordement hautement dopées.

3. Procédé selon la revendication 1, dans lequel les zones de contact sont des plans de métallisation.

4. Procédé selon la revendication 3, dans lequel les premières zones de contact sont des plans de métallisation disposés sur la première surface principale.

5. Procédé selon la revendication 3, dans lequel les premières zones de contact sont des plans de métallisation disposés au-dessous de la première surface principale.

6. Procédé selon l'une des revendications précédentes, dans lequel le matériau de connexion électroconducteur est appliqué par l'intermédiaire d'une séquence de métallisation supplémentaire.

7. Procédé selon l'une des revendications précédentes, dans lequel la première surface principale du premier substrat à semi-conducteur (1) est assemblée, après la formation des trous de contacts, avec un substrat auxiliaire (2) et, ensuite, amincie depuis la face du premier substrat à semi-conducteur (1) opposée à la première surface principale.

8. Procédé selon l'une des revendications précédentes, dans lequel le premier (1) et le second (3) substrat à semi-conducteur sont tout d'abord traités de manière identique et sont ensuite assemblés l'un à l'autre en image-miroir.

9. Procédé selon l'une des revendications précédentes,
dans lequel il est utilisé de l'étain comme matériau pour les premières taches de contact (8) et dans lequel il est utilisé du cuivre comme matériau pour les secondes taches de contact (9), ou
dans lequel il est utilisé du titane comme matériau pour les premières taches de contact (8) et dans lequel il est utilisé de l'or comme matériau pour les secondes taches de contact (9).

10. Procédé selon l'une des revendications précédentes, dans lequel les premières (8) et secondes (9) taches de contact ne sont pas toutes reliées de manière électroconductrice aux premières et aux secondes zones de contact.

11. Procédé selon l'une des revendications précédentes, dans lequel est réalisé, par un placement ajusté de la seconde surface principale du premier substrat à semi-conducteur (1) sur la surface du second substrat à semi-conducteur (3) avec élévation de température et application de force simultanées, un assemblage électroconducteur.

12. Procédé pour assembler une pluralité de composants à semi-conducteur, dans lequel le procédé selon l'une des revendications précédentes est répété de manière itérative et le n-ième composant à semi-conducteur respectif assume le rôle du premier composant à semi-conducteur, tandis que la pile de (n-1) composants à semi-conducteur assemblés assume le rôle du second composant à semi-conducteur.
